# EUROPÄISCHE PATENTSCHRIFT

(11) **EP 0 750 332 B1**
(45) Veröffentlichungstag und Bekanntmachung des Hinweises auf die Patenterteilung: **19.09.2001**
(21) Anmeldenummer: 96108482.9
(22) Anmeldetag: 28.05.1996
(51) Int. Cl.: H01J 37/24

(54) **Verfahren zur Regelung des Emissionsstromes einer Elektronenquelle und Elektronenquelle mit einer Regelung des Emissionsstromes**
Procedure for controlling the emission current of an electron source and electron source with emission current control
Procédé de régulation du courant d'émission d'une source d'électrons et source d'électrons avec régulation du courant d'émission

(30) Priorität: 20.06.1995 DE 19522221
(43) Veröffentlichungstag der Anmeldung: 27.12.1996
(73) Patentinhaber: Carl Zeiss, 89518 Heidenheim (Brenz) (DE)
(72) Erfinder: Härle, Rainer, 89522 Heidenheim (DE)

(56) Entgegenhaltungen:
- CH-A- 653 835
- GB-A- 2 081 941
- MARK K. DEBE AND D.C. JOHNSON: "Simple dc technique for precise electron beam current regulation" REVIEW OF SCIENTIFIC INSTRUMENTS., Bd. 47, Nr. 1, Januar 1976, NEW YORK US, Seiten 37-38, XP002055526
- PATENT ABSTRACTS OF JAPAN vol. 008, no. 127 (E-250), 14.Juni 1984 & JP 59 040449 A (MITSUBISHI DENKI KK), 6.März 1984,
- PATENT ABSTRACTS OF JAPAN vol. 008, no. 127 (E-250), 14.Juni 1984 & JP 59 040450 A (MITSUBISHI DENKI KK), 6.März 1984,

## Beschreibung

Die in Elektronenmikroskopen eingesetzten Elektronenquellen weisen in der Regel eine Triodenanordnung auf. Eine solche Triodenanordnung besteht aus drei Elektroden, einer die Elektronen emittierenden Kathode, einer Steuerelektrode zur Regelung des Elektronenstromes und einer Anode, auf die die emittierten Elektronen hinzubeschleunigt werden. Üblicherweise liegen die Kathode und die Steuerelektrode auf einem Hochspannungspotential von 10-30 kV bei Raster-Elektronenmikroskopen und von 80-300 kV bei Transmissions-Elektronenmikroskopen. Die Steuerelektrode dient zur Regelung des Elektronenstromes unabhängig von der Beschleunigungsspannung zwischen der Kathode und der Anode und dem Heizstrom der Kathode. Kathode und Steuerelektrode liegen üblicherweise auf hohem negativem Potential und die Anode auf Erdpotential, damit das im Elektronenmikroskop zu untersuchende Präparat ebenfalls auf Erdpotential liegen kann. Dabei ist das Potential der Steuerelektrode betragsmäßig etwas größer als das Potential der Kathode. Kathode und Steuerelektrode sind deshalb üblicherweise an den negativen Hochspannungsausgang der Hochspannungsquelle angeschlossen.

Eine Möglichkeit zur Regelung des Emissionsstromes ist es, im Hochspannungskreis zwischen der Steuerelektrode und der Kathode einen regelbaren Widerstand vorzusehen. Der von der Kathode emittierte Elektronenstrom bewirkt in Summe mit einem Rückkoppelstrom durch einen Rückkoppelwiderstand der Hochspannungsregelung an diesem Regelwiderstand einen Spannungsabfall, durch den im Sinne einer Spannungsteilerschaltung die Spannungsdifferenz zwischen der Kathode und der Steuerelektrode erzeugt wird. Durch Änderung des Widerstandes läßt sich der Emissionsstrom variieren. Um den Emissionsstrom mit einem vorgegebenen Sollwert zu vergleichen, ist es auch bereits bekannt, den Emissionsstrom auf der Niederspannungsseite der Hochspannungsquelle über einen Meßwiderstand zu messen und mit einem Sollwert zu vergleichen. Eine derartige Emissionsstromregelung ist beispielsweise vom Elektronenmikroskop mit der Bezeichnung "JEM - 1200 EX" der Fa. JEOL bekannt.

Nachteilig an dieser Anordnung ist, daß das auf Niederspannungspotential erzeugte Steuerungssignal an den variablen Widerstand auf Hochspannungspotential weitergegeben werden muß. Dies erfordert eine Hochspannungsisolation zwischen dem Antriebsmotor für den regelbaren Widerstand und dem regelbaren Widerstand selbst. Insbesondere bei Hochspannungen über 100 kV sind sehr lange Isolationsstrecken erforderlich, die einer kompakten Bauweise der Elektronenquelle entgegenstehen.

Aus der US 5,185,559 und der EP 0 159 214 sind darüber hinaus Transistorschaltungen zur Regelung des Emissionsstromes bekannt. Die Messung des Emissionsstromes erfolgt dabei auf dem Hochspannungspotential und für die Erzeugung der Spannungsdifferenz zwischen der Steuerelektrode und der Kathode sind zusätzliche regelbare Spannungsquellen auf Hochspannungspotential erforderlich. Zur Leistungsversorgung dieser Quellen werden sogenannte Isoliertransformatoren benötigt. Abgesehen davon, daß die Isoliertransformatoren bei Hochspannungen über 100 kV sehr aufwendig werden, besteht bei diesen Anordnungen das Problem, daß die für den Vergleich des tatsächlichen Emissionsstromes mit einem Soll-Emissionsstrom herangezogene Führungsgröße in Form eines Niederspannungspotentials an die auf Hochspannungspotential befindliche Regelschaltung weitergeleitet werden muß. Hierzu ist in der EP 0 159 214 bereits vorgeschlagen worden, einen Teil der Steuerschaltung niederspannungsseitig der Hochspannungsquelle vorzusehen und die Signale dieser Steuerschaltung optisch über Glasfasern der hochspannungsseitigen Regelschaltung zuzuführen. Jedoch benötigt auch diese Anordnung für die Erzeugung der Gitterspannung Isoliertransformatoren.

Aus der JP-A590 40449, der JP-A590 40450 und der CH653 835 sind jeweils Elektronenquellen bekannt, bei denen auf Niederspannungspotential der Elektronenstrom gemessen und mit einer Führungsgröße verglichen wird, und das aus dem Vergleich gewonnene Regelsignal optisch auf eine auf Hochspannungspotential liegende Regelschaltung übertragen wird. Die Strom und Spannungsversorgung für die auf Hochspannungspotential liegende Regelschaltung erfolgt auch hier über Isoliertransformatoren. Aus Review of Scientific Instruments, Volume 47, Nr. 1, (1976), Seiten 37 und 38 ist eine ähnlich aufgebaute Elektronenquelle für LEED Anwendungen mit maximalen Elektronenenergien bis 200 eV bekannt.

Aus der US 5,357,172 ist darüber hinaus die Regelung des Emissionsstromes bei einem Feldemissionsdisplay mittels Feldeffekt-Transistoren auf Niederspannungspotential bekannt. Abgesehen davon, daß hier insgesamt nur recht niedrige Spannungen von unter 100 Volt zum Einsatz kommen sollen, erfolgt die Regelung des Emissionsstromes über eine Änderung der Potentialdifferenz zwischen der Kathode und der Anode. Derartige Regelungen kommen jedoch bei Anwendungen, bei denen eine definierte Elektronenenergie gewünscht ist, wie beispielsweise in der Elektronenmikroskopie, nicht in Betracht.

Es ist das Ziel der vorliegenden Erfindung, ein Verfahren zur Emissionsstromregelung einer auf Hochspannungspotential liegenden Elektronenquelle anzugeben, das mit einem geringen elektronischen und mechanischen Aufwand auskommt und das eine kompakte Bauweise einer Elektronenquelle mit entsprechender Emissionsstromregelung gestattet. Es ist ein weiteres Ziel der Erfindung, eine Elektronenquelle mit einer entsprechend einfachen Emissionsstromregelung anzugeben.

Dieses Ziel wird erfindungsgemäß durch ein Verfahren mit den Merkmalen des Anspruches 1 und eine Elektronenquelle mit den Merkmalen der Ansprüche 3 und 10 gelöst. Vorteilhafte Ausgestaltungen der Erfindung ergeben sich aus den Merkmalen der abhängigen Ansprüche.

Beim erfindungsgemäßen Verfahren wird ein Meßsignal für den Emissionsstrom auf der Niederspannungsseite der Hochspannungsquelle erzeugt und ein anhand des Meßsignals erzeugtes Regelsignal optisch einer Regeleinrichtung auf Hochspannungspotential zugeführt. Die optische Zuführung des Regelsignals kann dabei mittels einer Lichtleitfaser oder eines Lichtwellenleiters erfolgen.

Eine Elektronenquelle nach der Erfindung weist dementsprechend eine elektronenemittierende Kathode, eine Steuerelektrode, eine Anode und eine Hochspannungsquelle zwischen der Kathode und der Anode auf. Im Hochspannungskreis der Hochspannungsquelle ist eine elektronische Regelungsschaltung für den Elektronenstrom und im Niederspannungskreis der Hochspannungsquelle ist eine den Elektronenstrom messende und aus diesem Meßsignal ein Steuersignal erzeugende Schaltung vorgesehen. Die Übertragung des Steuersignals vom Niederspannungskreis in den Hochspannungskreis erfolgt optisch über einen elektrisch isolierenden Lichtwellenleiter oder eine elektrisch isolierende Lichtleitfaser.

Dadurch daß die Messung des Elektronenstroms bei Niederspannungspotential erfolgt, ist ohne jeglichen Isolationsaufwand ein Vergleich des Meßsignals mit einer einen Sollwert angebenden Führungsgröße auf Niederspannungspotential möglich.

Die elektronische Regelschaltung im Hochspannungskreis ist vorteilhafterweise aus einer zwischen der Kathode und der Steuerelektrode geschalteten Parallelschaltung von Transistoren oder Feldeffekt-Transistoren (FET) und Widerständen aufgebaut. Die Potentialdifferenz zwischen der Kathode und der Steuerelektrode wird dadurch im Sinne einer Spannungsteilerschaltung wie bei dem eingangs erwähnten Stand der Technik mit einem Regelwiderstand erzeugt. Daher sind keine zusätzlichen Spannungsquellen, deren Leistungsversorgung über Isoliertransformatoren auf Hochspannungspotential transformiert wird, zur Erzeugung der Potentialdifferenz zwischen der Steuerelektrode und der Kathode erforderlich. Da sämtliche aktiven elektronischen Bauelemente, also die Transistoren oder Feldeffekt-Transistoren, innerhalb des Hochspannungskreises angeordnet sind und keine zusätzlichen Spannungsquellen zu deren Versorgung vorgesehen sind, weist die gesamte Anordnung eine hohe Betriebszuverlässigkeit auch im Falle von Hochspannungsüberschlägen auf.

Die Wahl zwischen konventionellen Transistoren und Feldeffekt-Transistoren hängt von der Größe des Emissionsstromes ab. Bei hohen Emissionsströmen können konventionelle Halbleitertransistoren eingesetzt werden, während bei den kleinen Emissionsströmen in Elektronenmikroskopen von weniger als 1 mA Feldeffektransistoren wegen ihrer geringeren Leistungsaufnahme vorzuziehen sind.

Bei einem vorteilhaften Ausführungsbeispiel weist die das Steuersignal erzeugende Schaltung eine Leuchtdiode und die elektronische Regelschaltung eine Photodiode oder einen Phototransistor im Basiskreis der Transistoren bzw. im Gatekreis der Feldeffekt-Transistoren auf. Das von der Leuchtdiode emittierte Licht wird dann in die Lichtleitfaser bzw. den Wellenleiter eingekoppelt und das aus der Lichtleitfaser oder dem Wellenleiter ausgekoppelte Licht steuert über die Photodiode oder den Phototransistor die Spannung im Basiskreis der Transistoren oder im Gatekreis der Feldeffekt-Transistoren, wodurch die Transistoren oder Feldeffekt-Transistoren mehr oder minder durchgeschaltet werden und dementsprechend der Spannungsabfall im Kollektor-Emitter-Kreis bzw. im Drain-Source-Kreis der Transistoren oder Feldeffekt-Transistoren variiert wird.

Zur Messung des Elektronenstromes kann ein einfacher Meßwiderstand zwischen der Hochspannungsquelle und der Anode vorgesehen sein, wobei die über den Meßwiderstand abfallende Spannung mittels eines Meßverstärkers ermittelt wird.

Jenachdem wie groß die Potentialdifferenz zwischen der Kathode und der Steuerelektrode maximal sein soll und wie groß entsprechend der Regelbereich für den Elektronenstrom ist, kann es sich als vorteilhaft erweisen, mehrere Parallelschaltungen aus Transistoren oder Feldeffekt-Transistoren und Widerständen seriell zwischen der Kathode und der Anode vorzusehen.

Nachfolgend werden Einzelheiten der Erfindung anhand der in den Figuren dargestellten Ausführungsbeispiele näher erläutert. Im einzelnen zeigen:
- Figur 1: einen Schaltplan eines ersten, einfachen Ausführungsbeispiels der Erfindung und
- Figur 2: einen Schaltplan eines zweiten Ausführungsbeispiels der Erfindung zur Erzeugung größerer Potentialdifferenzen zwischen der Anode und der Kathode.

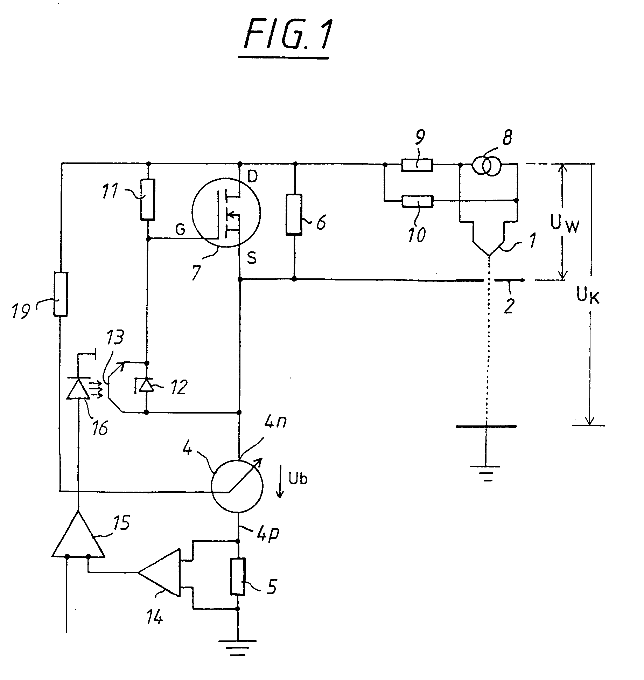

Im Ausführungsbeispiel der Figur 1 ist mit (1) die elektronenemittierende Kathode, mit (2) die Steuerelektrode (Wehnelt-Elektrode) und mit (3) die Anode bezeichnet. Die Anode (3) liegt auf Masse, wie dieses bei Elektronenquellen in Elektronenmikroskopen üblich ist. Die Kathode (1) und die Steuer- oder Wehnelt-Elektrode (2) sind an den negativen Pol (4n) einer regelbaren Hochspannungsquelle (4) angeschlossen. Der positive Pol (4p) der Hochspannungsquelle (4) liegt entweder über einen Meßwiderstand (5) auf Masse oder ist über einen Meßwiderstand (5) auf anderem Wege mit der Anode (3) verbunden.

Die Kathode (1) ist außerdem über einen Rückkoppelwiderstand (19) an die Regelung der Hochspannungsquelle (4) angeschlossen. Dadurch wird das Kathodenpotential U_{K} auf einen konstanten Wert geregelt.

Die Wehnelt-Elektrode (2) ist direkt ohne Vorwiderstand an den negativen Pol (4n) der Hochspannungsquelle (4) angeschlossen, während die Kathode (1) über eine Parallelschaltung aus einem Widerstand (6) und dem Drain-Source-Kreis eines Feldeffekt-Transistors (7) mit dem negativen Pol (4n) der Spannungsquelle (4) verbunden ist.

Im gezeigten Ausführungsbeispiel wird die Austrittsarbeit aus der Kathode durch Aufheizen der Kathode reduziert. Es handelt sich dementsprechend um eine thermische Emission oder thermische Feldemission. Zum Aufheizen der Kathode (1) ist der Hochspannung über einen Isoliertransformator (8) zusätzlich eine Heizspannung überlagert, deren Schwankungen durch die Symmetriewiderstände (9) und (10) derart gedämpft wird, daß solche Schwankungen keinen Einfluß auf das Kathodenpotential UK haben. Neben diesem Isoliertransformator (8), der natürlich nur im Falle einer thermischen Elektronenquelle oder einer thermischen Feldemissionsquelle erforderlich ist, erfordert die Regelung des Emissionsstromes nach Figur 1 keinerlei zusätzliche Spannungsquellen. Denn sämtliche Anschlüsse des Feldeffekttransistors (7) sind ohne Zwischenschaltung von Spannungsquellen an den Hochspannungskreis angelegt. Dabei liegt der Drain-Anschluß des Feldeffekttransistors (7) direkt auf Kathodenpotential U_{K} und der Source-Anschluß des Feldeffekttransistors (7) direkt auf dem Potential der Wehnelt-Elektrode (2), das zugleich der Ausgangsspannung U_{b} der Hochspannungsquelle (4) entspricht. Der Gate-Anschluß des Feldeffekttransistors (7) liegt ebenfalls im Hochspannungskreis, und zwar in einer Spannungsteilerschaltung aus einem Widerstand (11) und einem Phototransistor (13), die ebenfalls zwischen Kathode (1) und Wehnelt-Elektrode (2) geschaltet ist. Parallel zum Phototransistor (13) ist noch eine in Sperrichtung geschaltete Zehnerdiode (12) vorgesehen, die dem Schutz des Phototransistors (13) dient.

Zur Messung des Emissionsstromes wird die am Meßwiderstand (5) zwischen dem positiven Pol (4p) der Spannungsquelle (4) und dem Masseanschluß abfallende Spannung vor und hinter dem Meßwiderstand abgegriffen und den beiden Eingängen eines Meßverstärkers (14) zugeführt. Der Ausgang des Meßverstärkers (14) ist nachfolgend einem Eingang eines nachgeschalteten Reglers (15) zugeführt. Dem zweiten Eingang dieses Reglers (15) wird eine dem Sollstrom entsprechende Führungsgröße zugeführt, die vom Regler (15) mit dem Ausgang des Meßverstärkers (14) verglichen wird. Eine an den Ausgang des Reglers (15) angeschlossene Leuchtdiode (16) emittiert ein Lichtsignal entsprechend der Differenz zwischen der Führungsgröße und dem Ausgang des Meßverstärkers (14), das der lichtempfindlichen Fläche des Phototransistors (13) zugeführt wird. Jenachdem, wie stark der Emissionsstrom vom Sollwert abweicht und dementsprechend das Ausgangssignal des Meßverstärkers (14) der voreingestellten Führungsgröße entspricht, emittiert die Leuchtdiode (16) mehr oder weniger Licht. Dementsprechend wird der Phototransistor (13) im Hochspannungskreis mehr oder minder stark durchgeschaltet, wodurch wiederum aufgrund der Spannungsteilerschaltung aus Widerstand (11) und Phototransistor (13) im Gatekreis des Feldeffekttransistors (7) dieser mehr oder minder stark durchgeschaltet wird und sich demzufolge je nach verbleibender Größe des Widerstandes des Feldeffekttransistors (7) die Potentialdifferenz U_{W} zwischen der Kathode (1) und der Wehneltelektrode (2) ändert.

Beim Ausführungsbeispiel nach Figur ist die maximal erreichbare Potentialdifferenz zwischen der Kathode (1) und der Wehneltelektrode (2) durch die Durchbruchspannung des Feldeffekttransistors (7) begrenzt und beträgt etwa 1 kV. Diese Potentialdifferenz wird beispielsweise bei einer Hochspannung UK von -120 kV, einem Widerstand (11) im Gatekreis von 120 MOhm und einem Widerstand (6) parallel zum Feldeffekttransistor (7) von 20 MOhm erreicht. Sind höhere Potentialdifferenzen zwischen der Kathode (1) und der Wehneltelektrode (2) erforderlich, so können mehrere Parallelschaltungen von Widerständen (6) und Transistoren (7) seriell hintereinander zwischen der Kathode (1) und der Wehneltelektrode (2) vorgesehen sein.

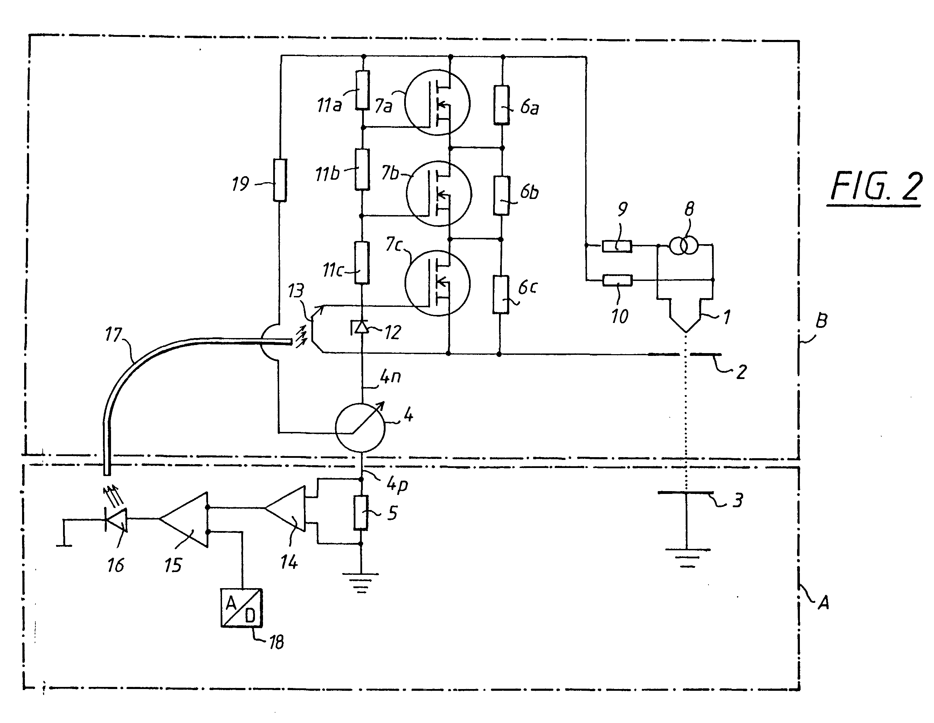

Das Ausführungsbeispiel nach Figur 2 ist dem Ausführungsbeispiel nach Figur 1 sehr ähnlich. Identische Gegenstände sind deshalb in der Figur 2 mit denselben Bezugszeichen versehen wie in der Figur 1. Ein wesentlicher Unterschied zum Ausführungsbeispiel nach Figur 1 ist, daß beim Ausführungsbeispiel nach Figur 2 drei identische Widerstände (6a, 6b, 6c) seriell der Kathode (1) und der Wehneltelektrode (2) zwischengeschaltet sind und daß parallel zu den drei Widerständen (6a, 6b, 6c) drei identische Feldeffekt-Transistoren (7a, 7b, 7c) seriell hintereinander geschaltet sind, wobei jeweils der Drain-Anschluß des einen Feldeffekt-Transistors mit dem Source-Anschluß des anderen Feldeffekt-Transistors verbunden ist. Zusätzlich sind auch im Gatekreis der Feldeffekt-Transistoren (7a, 7b, 7c) drei identische Widerstände (11a, 11b, 11c) als Spannungsteiler vorgesehen. Durch die serielle Hintereinanderschaltung von drei Schaltungsanordnungen, die jeweils aus Source-Drain-Widerstand (6), Feldeffekt-Transistor (7) und Gate-Drain-Widerstand (11) aus der Figur 1 bestehen, läßt sich bei der Anordnung gemäß Figur 2 eine dreimal höhere Potentialdifferenz zwischen der Kathode (1) und der Wehneltelektrode (2) erzeugen. Sind noch höhere Potentialdifferenzen erforderlich, so können ohne Probleme weitere Parallelschaltungen aus Widerständen (6, 11) und Feldeffekt-Transistoren (7) seriell hintereinander geschaltet werden.

In der Figur 2 ist zur Verdeutlichung noch einmal durch die strichpunktierten Linien der Hochspannungsteil (B) und der Niederspannungsteil (A) eingezeichnet. Der Niederspannungsteil (A) liegt im wesentlichen auf Massepotential. Die einzigen elektrischen Verbindungen zwischen dem Niederspannungsteil (A) und dem Hochspannungsteil (B) sind die Hochspannungsquelle (4) und die Beschleunigungsstrecke für die Elektronen zwischen der Wehneltelektrode (2) und der Anode (3). Die bezüglich der Hochspannung auf Massepotential erzeugten Regelsignale für den Emissionsstrom werden optisch über eine elektrisch isolierende Lichtleitfaser oder einen elektrisch isolierenden Lichtwellenleiter (17) dem Hochspannungsteil (B) zugeführt. Die Lichtleitfaser (17) wirkt damit als Isolator zwischen dem Niederspannungsteil (A) und dem Hochspannungsteil (B). Die Führungsgröße für den Emissionsstrom wird über eine nicht dargestellte Schnittstelle vom Steuerungscomputer über einen A/D-Wandler (18) im Niederspannungsteil (A) geliefert.

Ein wesentlicher Vorteil der erfindungsgemäßen Emissionsstromregelung ist, daß die elektronischen Bauteile sowie die Glasfaser (17) Massenprodukte sind und daß weder isolierte Regler noch Isoliertransformatoren benötigt werden. Dadurch läßt sich die Steuerungselektronik auch im Falle von Hochspannungen über 100 kV problemlos auf zwei kleinen Platinen anordnen, von denen eine im Hochspannungsteil der Elektronenquelle und die zweite im Niederspannungsteil der Elektronenquelle angeordnet ist. Dadurch gestattet die vorliegende Erfindung eine kompakte Bauweise selbst im Falle von hohen Hochspannungen. Als weiterer Vorteil ergibt sich, daß auch im Falle unterschiedlicher erforderlicher Potentialdifferenzen zwischen der Kathode und der Wehneltelektrode lediglich die Anzahl der parallelgeschalteten Feldeffekt-Transistoren (7) und Widerstände (6, 11) an die erforderliche Wehneltspannung angepaßt werden muß.

## Patentansprüche

1. Verfahren zur Regelung des Emissionsstromes einer auf einem Hochspannungspotential liegenden Elektronenquelle mit einer Kathode (1), einer Steuerelektrode (2) und einer Anode (3), wobei ein Meßsignal für den Emissionsstrom auf Niederspannungspotential erzeugt und ein auf Niederspannungspotential daraus erzeugtes Regelsignal optisch einer elektronischen Regeleinrichtung auf Hochspannungspotential zugeführt wird, und wobei sämtliche Versorgungsspannungen für die elektronische Regeleinrichtung ausschließlich durch Spannungsteile der Potentialdifferenz zwischen der Kathode (1) und der Steuerelektrode (2) erzeugt werden.

2. Verfahren nach Anspruch 1, wobei das Regelsignal über eine Lichtleitfaser (17) oder einen Lichtwellenleiter der Regeleinrichtung zugeführt wird.

3. Elektronenquelle mit einer Elektronen Emittierenden Kathode (1), einer Steuerelektrode (2), einer Anode (3), einer der Anode (3) und der Kathode (1) zwischengeschalteten Hochspannungsquelle (4), einer im Hochspannungskreis (B) der Hochspannungsquelle (4) liegenden elektronischen Regelschaltung (6, 7, 11, 12, 13) für den Elektronenstrom, und einer den Elektronenstrom messenden und daraus ein Steuersignal erzeugenden Schaltung (5, 14, 15, 16) auf einem Niederspannungspotential, wobei das Steuersignal der elektronischen Regelschaltung optisch zugeführt ist, und wobei sämtliche Versorgungsspannungen für die elektronische Regelschaltung ausschließlich durch Spannungsteilung der Potentialdifferenz zwischen der Kathode (1) und der Steuerelektrode (2) erzeugt sind.

4. Elektronenquelle nach Anspruch 3, wobei die elektronische Regelschaltung eine der Kathode (1) und der Steuerelektrode (2) zwischengeschaltete Parallelschaltung von Transistoren oder Feldeffekt-Transistoren (7; 7a, 7b, 7c) und Widerständen (6; 6a, 6b, 6c) umfaßt.

5. Elektronenquelle nach Anspruch 4, wobei mehrere Parallelschaltungen aus Transistoren oder Feldeffekt-Transistoren (7a, 7b, 7c) und Widerständen (6a, 6b, 6c) seriell der Kathode (1) und der Steuerelektrode (2) zwischengeschaltet sind.

6. Elektronenquelle nach einem der Ansprüche 3-5, wobei für die optische Übertragung des Regelsignals eine Lichtleitfaser (17) oder ein Lichtwellenleiter vorgesehen ist.

7. Elektronenquelle nach einem der Ansprüche 4-6, wobei die das Steuersignal erzeugende Schaltung eine Lichtquelle, vorzugsweise eine Leuchtdiode (16), und die elektronische Regelschaltung einen Lichtdetektor, vorzugsweise eine Photodiode oder einen Phototransistor (13), im Basiskreis der Transistoren bzw. im Gatekreis der Feldeffekt-Transistoren aufweist.

8. Elektronenquelle nach einem der Ansprüche 3-7, wobei zur Messung des Elektronenstroms ein Meßwiderstand (5) zwischen der Hochspannungsquelle (4) und der Anode (3) vorgesehen ist.

9. Elektronenquelle mit
- einer elektronenemittierenden Kathode (1),
- einer Steuerelektrode (2) zur Regelung des Emissionsstromes der Kathode (1),
- einer Anode (3),
- einer der Anode und der Kathode zwischengeschalteten Hochspannungsquelle (4),
- einer Schaltung aus Feldeffekt-Transistoren (7; 7a, 7b, 7c) und Widerständen (6; 6a, 6b, 6c) im Hochspannungskreis zwischen der Kathode und der Steuerelektrode, wobei die Potentialdifferenz zwischen der Steuerelektrode und der Kathode über die Feldeffekt-Transistoren (7; 7a, 7b, 7c) regelbar ist,
- einem Meßwiderstand (5) zwischen der Hochspannungsquelle (4) und der Anode (3),
- einem Regler zum Vergleich des am Meßwiderstand (5) gemessenen Emissionsstromes mit einer Führungsgröße,
- einem Licht emittierenden Element (16) am Ausgang des Reglers (15),
- einem lichtempfindlichen Element (13) im Gatekreis der Feldeffekt-Transistoren (7; 7a, 7b, 7c),
- einer Lichtleitfaser oder einem Lichtwellenleiter zur Übertragung des vom Licht emittierenden Element (16) emittierten Lichts zum lichtempfindlichen Element (13),
- wobei die Spannungsversorgung der Feldeffekt-Transistoren (7; 7a, 7b, 7c) ausschließlich durch Spannungsteilung der Potentialdifferenz zwischen der Kathode (1) und der Steuerelektrode (2) erfolgt, die durch die an den Widerständen (6a, 6b, 6c) und den Transistoren (7; 7a, 7b, 7c) aufgrund des Emissionsstromes abfallende Spannung erzeugt ist.

10. Elektronenmikroskop mit einer Elektronenquelle nach einem der Ansprüche 3 - 9.

## Claims

1. Method for regulating the emission current of an electron source at a high-voltage potential and having a cathode (1), a control electrode (2) and an anode (3), in which a measurement signal for the emission current is generated at low-voltage potential and a regulating signal generated therefrom at low-voltage potential is optically fed to an electronic regulating device at high-voltage potential, and in which all of the supply voltages for the electronic regulating device are generated exclusively by voltage parts of the potential difference between the cathode (1) and the control electrode (2).

2. Method according to Claim 1, in which the regulating signal is fed to the regulating device via an optical fibre (17) or an optical waveguide.

3. Electron source having an electron-emitting cathode (1), a control electrode (2), an anode (3), a high-voltage source (4) connected between the anode (3) and the cathode (1), an electronic regulating circuit (6, 7, 11, 12, 13) for the electron current, the said circuit being located in the high-voltage circuit (B) of the high-voltage source (4), and a circuit (5, 14, 15, 16) at a low-voltage potential, the said circuit measuring the electron current and generating a control signal therefrom, in which the control signal is optically fed to the electronic regulating circuit, and in which all of the supply voltages for the electronic regulating circuit are generated exclusively by voltage division of the potential difference between the cathode (1) and the control electrode (2).

4. Electron source according to Claim 3, in which the electronic regulating circuit comprises a parallel circuit of transistors or field-effect transistors (7; 7a, 7b, 7c) and resistors (6; 6a, 6b, 6c) which is connected between the cathode (1) and the control electrode (2).

5. Electron source according to Claim 4, in which a plurality of parallel circuits comprising transistors or field-effect transistors (7a, 7b, 7c) and resistors (6a, 6b, 6c) are connected in series between the cathode (1) and the control electrode (2).

6. Electron source according to one of Claims 3-5, in which an optical fibre (17) or an optical waveguide is provided for the optical transmission of the regulating signal.

7. Electron source according to one of Claims 4-6, in which the circuit which generates the control signal has a light source, preferably a light-emitting diode (16), and the electronic regulating circuit has a light detector, preferably a photodiode or a phototransistor (13), in the base circuit of the transistors or in the gate circuit of the field-effect transistors.

8. Electron source according to one of Claims 3-7, in which, in order to measure the electron current, a measuring resistor (5) is provided between the high-voltage source (4) and the anode (3).

9. Electron source having
- an electron-emitting cathode (1),
- a control electrode (2) for regulating the emission current of the cathode (1),
- an anode (3),
- a high-voltage source (4) connected between the anode and the cathode,
- a circuit comprising field-effect transistors (7; 7a, 7b 7c) and resistors (6; 6a, 6b, 6c) in the high-voltage circuit between the cathode and the control electrode, in which the potential difference between the control electrode and the cathode can be regulated via the field-effect transistors (7; 7a, 7b, 7c),
- a measuring resistor (5) between the high-voltage source (4) and the anode (3),
- a regulator for comparing the emission current measured at the measuring resistor (5) with a reference variable,
- a light-emitting element (16) at the output of the regulator (15),
- a light-sensitive element (13) in the gate circuit of the field-effect transistors (7; 7a, 7b, 7c),
- an optical fibre or an optical waveguide for transmitting the light emitted by the light-emitting element (16) to the light-sensitive element (13),
- in which the voltage supply of the field-effective transistors (7; 7a, 7b, 7c) is effected exclusively by voltage division of the potential difference between the cathode (1) and the control electrode (2) which is generated by the voltage dropped across the resistors (6a, 6b, 6c) and the transistors (7; 7a, 7b, 7c) on account of the emission current.

10. Electron microscope having an electron source according to one of Claims 3-9.

## Revendications

1. Procédé de régulation du courant d'émission d'une source d'électrons qui se trouve à un potentiel de haute tension avec une cathode (1), une électrode de commande (2) et une anode (3), un signal de mesure pour le courant d'émission étant généré à un potentiel de basse tension et un signal de régulation à un potentiel de basse tension généré à partir de celui-ci étant acheminé de manière optique à un dispositif de régulation électronique à un potentiel de haute tension, et toutes les tensions d'alimentation du dispositif de régulation électronique étant exclusivement générées par les parties de tension de la différence de potentiel entre la cathode (1) et l'électrode de commande (2).

2. Procédé selon la revendication 1, avec lequel le signal de régulation est acheminé au dispositif de régulation par le biais d'une fibre optique (17) ou d'un guide d'ondes lumineuses.

3. Source d'électrons avec une cathode (1) émettant des électrons, une électrode de commande (2), une anode (3), une source de haute tenson (4) branchée entre l'anode (3) et la cathode (1), un circuit électronique de régulation (6, 7, 11, 12, 13) du courant d'électrons qui se trouve dans le circuit de haute tension (B) de la source de haute tension (4) et un circuit (5, 14, 15, 16) mesurant le courant d'électrons et générant à partir de là un signal de commande à un potentiel de basse tension, le signal de commande du circuit électronique de régulation étant acheminé de manière optique et toutes les tensions d'alimentation du circuit électronique de régulation étant exclusivement générées par division de la tension de la différence de potentiel entre la cathode (1) et l'électrode de commande (2).

4. Source d'électrons selon la revendication 3, avec laquelle le circuit électronique de régulation comprend un circuit parallèle composé de transistors ou de transistors à effet de champ (7 ; 7a, 7b, 7c) et de résistances (6 ; 6a, 6b, 6c) branché entre la cathode (1) et l'électrode de commande (2).

5. Source d'électrons selon la revendication 4, avec laquelle plusieurs circuits parallèles composés de transistors ou de transistors à effet de champ (7a, 7b, 7c) et de résistances (6a, 6b, 6c) sont branchés en série entre la cathode (1) et l'électrode de commande (2).

6. Source d'électrons selon l'une des revendications 3-5, avec laquelle une fibre optique (17) ou un guide d'ondes lumineuses est prévu pour la transmission optique du signal de régulation.

7. Source d'électrons selon l'une des revendications 4-6, avec laquelle le circuit qui génère le signal de commande présente une source de lumière, de préférence une diode électroluminescente (16), et le circuit électronique de régulation présente un détecteur de lumière, de préférence une photodiode ou un phototransistor (13), dans le circuit de base des transistors ou dans le circuit de gâchette des transistors à effet de champ.

8. Source d'électrons selon l'une des revendications 3-7, avec laquelle une résistance de mesure (5) est prévue entre la source de haute tension (4) et l'anode (3) pour mesurer le courant d'électrons.

9. Source d'électrons comportant
- une cathode (1) émettant des électrons,
- une électrode de commande (2) pour réguler le courant d'émission de la cathode (1),
- une anode (3),
- une source de haute tension (4) branchée entre l'anode et la cathode,
- un circuit composé de transistors à effet de champ (7 ; 7a, 7b, 7c) et de résistances (6 ; 6a, 6b, 6c) dans le circuit de haute tension entre la cathode et l'électrode de commande, la différence de potentiel entre l'électrode de commande et la cathode pouvant être réglée par le biais des transistors à effet de champ (7 ; 7a, 7b, 7c),
- une résistance de mesure (5) entre la source de haute tension (4) et l'anode (3),
- un régulateur pour comparer le courant d'émission mesuré au niveau de la résistance de mesure (5) avec une grandeur de référence,
- un élément émetteur de lumière (16) à la sortie du régulateur (15),
- un élément sensible à la lumière (13) dans le circuit de gâchette des transistors à effet de champ (7 ; 7a, 7b, 7c),
- une fibre optique ou un guide d'ondes lumineuses pour transmettre la lumière émise par l'élément émetteur de lumière (16) vers l'élément sensible à la lumière (13),
- l'alimentation en tension des transistors à effet de champ (7 ; 7a, 7b, 7c) étant exclusivement effectuée par division de la tension de la différence de potentiel entre la cathode (1) et l'électrode de commande (2), laquelle est générée par la chute de tension aux bornes des résistances (6 ; 6a, 6b, 6c) et des transistors (7 ; 7a, 7b, 7c) en raison du courant d'émission.

10. Microscope électronique muni d'une source d'électrons selon l'une des revendications 3-9.
